# EUROPÄISCHE PATENTSCHRIFT

(11) **EP 1 505 399 B1**
(45) Veröffentlichungstag und Bekanntmachung des Hinweises auf die Patenterteilung: **25.06.2008**
(21) Anmeldenummer: 04014616.9
(22) Anmeldetag: 22.06.2004
(51) Int. Cl.: G01R 31/3183, G06F 11/36, G06F 11/263

(54) **Verfahren zum Erzeugen von Testdaten zum Austesten der Funktionsfähigkeit einer datenverarbeitenden Schaltung**
Method for Generating Test Data for functional test of data processing circuits
Procédé pour génération de données de test pour test fonctionnel d'un circuit de traitement de données

(30) Priorität: 24.06.2003 DE 10328237
(43) Veröffentlichungstag der Anmeldung: 09.02.2005
(73) Patentinhaber: Giesecke & Devrient GmbH, 81677 München (DE)
(72) Erfinder: Polivaev, Dmitry, 81739 München (DE); Aiglstorfer, Ernst, 81249 München (DE)

(56) Entgegenhaltungen:
- DE-A1- 10 206 287
- US-A- 4 677 620
- US-A- 5 390 325
- US-A- 6 112 312
- US-B1- 6 195 765

## Beschreibung

Die Erfindung geht aus von einem Verfahren nach der Gattung des Hauptanspruchs. Zur Feststellung der Funktionsfähigkeit und der Zuverlässigkeit von integrierten Schaltkreisen ist es üblich, sie mit Testdaten zu betreiben, die speziell zusammengestellt wurden, um mögliche Fehler aufzuzeigen. Ein fundamentales Problem hierbei ist die Zusammenstellung geeigneter Testdaten. In der Regel ist die Zahl der möglichen Testfälle so groß, daß eine Auswahl getroffen werden muß. Die Durchführung der Auswahl bildet deshalb ein wesentliches Element einer jeden Testdatenerzeugung. Die Veröffentlichung "Automatische Testdatengenerierung zur Unterstützung des Softwaretests", Walter Gutjahr, in: Informatik Forsch. Entw. 1993, S. 128-136, gibt einen Überblick über verschiedene Verfahren zur Auswahl von Testfällen und zur Erzeugung von Testdaten. Alle vorgestellten Verfahren zielen darauf ab, die Testfallerzeugung nach Vornahme desjenigen Arbeitsteiles, der menschlicher Kreativität bedarf, vollständig zu automatisieren. Der gesamte Überblick steht allerdings unter dem Vorbehalt, daß keines der beschriebenen Verfahren besonders für spezielle Anwendungen geeignet ist, da bestimmten Vorteilen jeweils auch erhebliche Nachteile, etwa eine schwer erlernbare Spezifikationssprache, gegenüberstehen.

Aus der US 6,112,312 A1 ist ein Verfahren zur Entwicklung einer Testprozedur für nichtressourcenbeschränkte Microcomputer bekannt. Das vorgeschlagene Verfahren geht von einem Grundtestmodul aus, das zunächst kopiert und dann zu einer Testprozedur modifizert wird. Die Testprozedur wird von dem zu testenden Mikrocomputer sowie von einem Simulationssystem ausgeführt, die Ergebnisse werden verglichen. Indem das Grundtestmodul alle möglichen Betriebsbedingungen grundsätzlich enthält, befreit es einen Testingenieur bei der Entwicklung von Testprozeduren davon, diese berücksichtigen zu müssen. Davon abgesehen stellt die bekannte Lösung aber unverändert hohe Anforderungen an die Kenntnisse des Testingeneurs im Hinblick auf die zu testende Schaltung und deren Programmierung.

Aus der US 6,195,765 B1 ist ein Verfahren zum Testen von Anwendungsprogrammen in unterschiedlichen Testfällen bekannt, nach dem zu einer Basisversion einer Anwendung eine Vielzahl von modifizierten Versionen der Anwendung gebildet wird. Die modifizierten Versionen unterscheiden sich dabei von der Basisversion in einer oder mehreren Testvariablen. Das Verfahren ist nutzerfreundlich, läßt aber nur jeweils kleine Änderungen zu und ist vergleichsweise unflexibel.

Aus der DE 102 06 287 Al ist ein Verfahren zum Erzeugen von Testdaten bekannt, das insbesondere zum Testen des integrierten Schaltkreises einer Chipkarte geeignet ist. Grundlage des vorgeschlagenen Verfahrens bildet eine Wissensbasis, in der für alle zu testenden Befehle alle möglichen Vorbedingungskonstellationen mit den jeweils zugeordneten Nachbedingungen zusammengefaßt sind. Mittels der Wissensbasis stellt sodann ein Testsystem nach Vorgabe eines zu testenden Befehles die dazu notwendige Vorbedingungskonstellation her. Hierbei führt das Testsystem unter Zugriff auf die Wissensbasis rekursiv so lange weitere Befehle aus, bis der ursprünglich vorgegebene Befehl entweder ausführbar oder nicht ausführbar ist. Das Verfahren erlaubt eine sehr einfache Testdatenerzeugung, in dem zu testende Befehle willkürlich vorgegeben werden. Voraussetzung für ein Funktionieren des Verfahrens ist allerdings eine sorgfältige Erstellung der Wissensbasis.

Aus der WO 94/15289 sind ein Testsystem sowie ein Testverfahren bekannt, das darauf abstellt, Regeln zu entwickeln, welche eine zu prüfende Software modellieren und verifizieren. Nach Festlegung der Regeln erzeugt das Testsystem selbsttätig Testszenarien. Dabei stützt es sich u.a. auf festgelegte Vorund Nachbedingungen, die auf Spezifikationen für zu testende Programmroutinen beruhen.

Allen bekannten Verfahren und Testsystemen ist gemein, daß sie, wenn sie zuverlässige Ergebnisse liefern sollen, hohe Anforderungen hinsichtlich der jeweils zu leistenden Vorbereitungsarbeiten an den mit der Testdurchführung befaßten Testingenieur stellen.

Vor diesem Hintergrund ist es Aufgabe der Erfindung ein Verfahren anzugeben, das die Zusammenstellung geeigneter Testdaten und die Entwicklung brauchbarer Testprozeduren erleichtert.

Diese Aufgabe wird gelöst durch ein Verfahren mit den Merkmalen des Hauptanspruchs. Das erfindungsgemäße Verfahren basiert auf dem Ansatz, daß sinnvolle Testprozeduren zum Austesten datenverarbeitender Schaltungen häufig durch geringfügige Änderung einer existierenden Basistestprozedur erstellt werden können. Dieser Umstand wird erfindungsgemäß genutzt, um den Prozeß der Testprozedurerstellung durch automatisch generierte visuelle Hilfestellungen zu unterstützen. Auf einer Anzeige werden hierzu dem mit der Testprozedurerstellung befaßten Testingenieur die Basistestprozedur sowie die hieraus abgeleiteten weiteren Testprozeduren so dargestellt, daß die jeweils vorgenommenen Abwandlungen unmittelbar erkennbar sind. Eine abgeleitete Testprozedur wird beispielsweise jeweils zeilengenau neben der Basistestprozedur gezeigt, wobei die Abweichungen in der abgeleiteten Testprozedur gegenüber der Basistestprozedur farblich unterlegt sind.

Indem das erfindungsgemäße Verfahren die Unterschiede einer abgeleiteten Testprozedur zu einer Basistesteprozedur leicht erkennbar macht, lassen sich aus einer Basistestprozedur abgeleitete Testprozeduren gut analysieren und modifizieren. Hierdurch lassen sich in einfacher Weise große Testprozedurfamilien entwickeln, in denen ausgehend von einer Basistestprozedur eine Vielzahl von Testfällen geprüft werden kann. Indem die Testprozedurentwicklung sich, sobald einmal eine Basistestprozedur erstellt wurde, auf die Behandlung von Unterschieden beschränkt und nicht mehr stets die vollständige Erfassung der gesamten Testprozedur erfordert, kann die Testprozedurentwicklung auch von weniger erfahrenen Testingenieuren durchgeführt werden. Insgesamt läßt sich durch das erfindungsgemäße Verfahren in vorteilhafter Weise eine deutliche Beschleunigung der Testprozedurentwicklung erreichen. Insbesondere gilt dies gilt bei komplizierten Testprozeduren. Ein weiterer Vorteil des erfindungsgemäßen Verfahrens besteht dabei darin, daß vor allem die abgeleiteten Testprozeduren gut nachvollziehbar und gegebenenfalls korrigierbar sind. Dies wirkt sich wiederum positiv auf die Testprozedurqualität insgesamt aus. Das erfindungsgemäße Verfahren kann im übrigen leicht auf bestehenden Testeinrichtungen eingesetzt werden. In der Regel sind insbesondere keine besonderen Anpassungen der Hardware erforderlich.

Weitere vorteilhafte Ausgestaltungen und zweckmäßige Weiterbildungen des erfindungsgemäßen Verfahren ergeben sich aus den in den Unteransprüchen genannten Merkmalen.

Unter Bezugnahme auf die Zeichnung wird nachfolgend ein Ausführungsbeispiel der Erfindung näher erläutert.

### Es zeigen

Figur 1: die Struktur eines zur Ausführung des erfindungsgemäßen Verfahrens geeigneten Testsystems,
Figur 2: ein Flußdiagramm der Ausführung einer Testprozedur,
Figur 3: eine Darstellung der Entwicklung von abgeleiteten Testprozeduren aus einer Basistestprozedur.

### Beschreibung

Nachfolgend wird davon ausgegangen, daß das erfindungsgemäße Verfahren zum Austesten der Funktionsfähigkeit des integrierten Schaltkreises einer Chipkarte 10 eingesetzt wird. Die Chipkarte 10 steht dabei stellvertretend für eine beliebige datenverarbeitende Schaltung, welche aufgrund einer eingehenden Anweisung in vorbestimmter Weise eine Antwort bildet.

Die Chipkartenanwendung eignet sich für Beschreibungszwecke besonders, weil Chipkarten mit der Außenwelt mittels eines vergleichsweise begrenzten Kommandosatzes kommunizieren und der Umfang des Kommandosatzes wesentlich die Zahl der zum Austesten erforderlichen Testszenarien bestimmt. Deren Zahl wiederum schlägt sich in der Zahl der zu erstellenden Testprozeduren nieder, da in erster Näherung für jedes Testszenario eine Testprozedur erstellt werden muß.

Das erfindungsgemäße Testverfahren ist grundsätzlich aber nicht auf das Testen von Chipkarten oder vergleichbaren tragbaren Datenträgern beschränkt. Die Chipkarte 10 steht vielmehr stellvertretend für eine beliebige datenverarbeitende Schaltung, welche aufgrund einer eingehenden Anweisung in vorbestimmter Weise eine Datenantwort bildet. Insbesondere eignet sich das erfindungsgemäße Verfahren zum Testen beliebiger integrierter Schaltkreise. Entsprechend besteht auch hinsichtlich der Zahl der zu entwerfenden Testszenarien grundsätzlich keine Einschränkung.

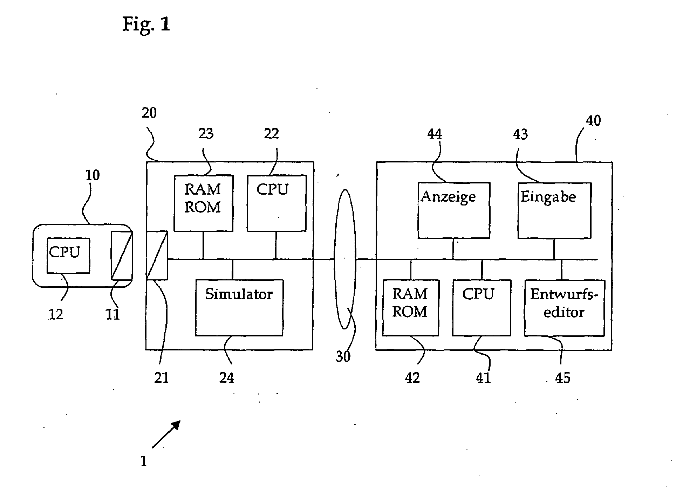

Figur 1 zeigt eine Chipkarte 10, die über eine Schnittstelle 11 mit einer Funktionsaustestanordnung 1 kommuniziert. Die Funktionsaustestanordnung 1 umfaßt eine Prüfeinrichtung 20 und eine Testentwurfsstation 40, die über ein Datennetz 30 verbunden sind, und weist eine zu der Schnittstelle 11 korrespondierende Schnittstelle 21 auf.

Wesentliches Element der Chipkarte 10 ist ein integrierter Schaltkreis 12, der einen Mikrocontroller besitzt und die Ausführung von für die Chipkarte 10 eigentümlicher Software erlaubt. Über die Schnittstelle 11 kommuniziert der integrierte Schaltkreis 12 mittels sogenannter "APDU (Application Protocol Data Unit)"-Kommandos mit der Außenwelt, in Figur 1 mit der Prüfeinrichtung 20. Chipkarten 10, deren integrierte Schaltkreise 12, chipkarteneigentümliche Software sowie der Aufbau von APDU-Kommandos sind hinlänglich bekannt und beispielsweise in dem Handbuch der Chipkarten, Rankl, Effing, 4. Auflage beschrieben, weshalb an dieser Stelle hierauf nicht weiter eingegangen wird. Nachfolgend soll ferner nicht mehr streng zwischen Chipkarte 10, integriertem Schaltkreis 12 und Schnittstelle 11 unterschieden; unter dem Begriff Chipkarte wird vielmehr stets auch der integrierte Schaltkreis 12 sowie die Schnittstelle 11 verstanden.

Die Prüfeinrichtung 20 ist von an sich bekanntem Typ. Sie basiert auf einem üblichen Computer und weist eine zentrale Prozessoreinheit 22 zur Ausführung von Programmen sowie eine Speichereinrichtung 23 mit flüchtigen und nichtflüchtigen Speichermitteln auf. Die Prüfeinrichtung 20 dient insbesondere zur Ausführung von Testprozeduren, um damit die Funktionsfähigkeit einer Chipkarte 10 auszutesten. Die Testdurchführung wird von einem Simulator 24 gesteuert, der vorzugsweise in Form eines Simulatorprogramms in der Prüfeinrichtung 20 realisiert ist. Der Simulator 24 erhält Testdaten in Gestalt von Testprozeduren, die Anweisungen zur Ausführung durch die Chipkarte sowie Anweisungen an den Simulator 24 enthalten. Die jeweils für die Chipkarte 10 bestimmten Anweisungen setzt der Simulator 24 in ein zur Kommunikation mit der Chipkarte 10 geeignetes Protokoll um und wertet die von der Chipkarte 10 zurückgelieferten Antworten gemäß den für den Simulator 24 bestimmten Anweisungen aus.

Über das Datennetz 30 ist die Prüfeinrichtung 20 mit der Testentwurfsstation 40 verbunden. Das Datennetz 30 bewirkt dabei die physische und damit örtliche Trennbarkeit von Prüfeinrichtung 20 und Testentwurfsstation 40 und dient hierbei dazu, in der Testentwurfsstation 40 erstellte Testdaten an die Prüfeinrichtung 20 übertragen zu können. Das Datennetz 30 kann jede zu diesem Zweck geeignete Form besitzen. Als Datennetz 30 in diesem Sinne wird auch der Transport von Testdaten auf geeigneten Datenträgern, etwa Compact Discs angesehen.

Die Testentwurfsstation 40 basiert ebenfalls auf einem üblichen Computer und weist dessen charakteristische Komponenten auf. Insbesondere besitzt sie eine zentrale Prozessoreinheit 41, eine Speichereinrichtung 42 mit flüchtigen und nichtflüchtigen Speichermitteln sowie eine graphische Nutzerschnittstelle mit Eingabemitteln 43 zur Eingabe von Daten und Informationen durch einen Testingenieur sowie einer Anzeige 44 zur visuellen Darstellung von in der Testentwurfsstation 40 bearbeiteten Daten und Informationen. Die Eingabemittel 43 sind typischerweise eine Tastatur, die Anzeige 44 ein zur Darstellung alphanumerischer Zeichen und graphischer Elemente geeigneter Bildschirm.

Die in Figur 1 wiedergegebene Struktur wurde zur Erleichterung der Beschreibung des erfindungsgemäßen Verfahrens gewählt. Tatsächliche Funktionsaustestanordnungen 1 können bei gleicher Grundfunktionalität auch gänzlich andere Strukturen besitzen. So können die Eingabemittel 43 akustische Mittel für eine sprachgesteuerte Eingabe umfassen oder die Anzeige 44 einen Drucker. Die Anzeige 44 kann auch mehrere Bildschirme aufweisen, so daß mehrere Testingenieure gleichzeitig an der Erstellung eines Testskriptes arbeiten können. Die Prüfeinrichtung 20 kann über andere Schnittstellen 21 an andere zu testende integrierte Schaltkreise 10 angepaßt sein. Die Funktionsaustestanordnung 1 kann auch weitere Komponenten aufweisen. Prüfeinrichtung 20, Datennetz 30 und Testentwurfsstation 40 können ferner in einem Gerät integriert ausgeführt sein.

Wichtige Funktionalität der Testentwurfsstation 40 ist die Bereitstellung von Testdaten, mit denen die Funktionsfähigkeit eines integrierten Schaltkreises 12 ausgetestet werden kann. Die Testdaten werden in Form von Testsprozeduren bereitgestellt, die auf dem Gebiet der Chiparten die Gestalt von Testskripten haben. Testskripte sind Sequenzen von Anweisungen, um eine auszutestende Chipkarte 10 zur Durchführung einer Datenverarbeitung und anschließend zur Rückgabe einer Antwort zu veranlassen. Daneben enthalten Testskripte Anweisungen für den Simulator 24, um die Durchführung der durch ein Testskript beschriebenen Testprozedur zu steuern. Die Anweisungen an die Chipkarte 10 beinhalten insbesondere Kommandos, Parameter und Daten, die in der Chipkarte 10 bestimmte Testbedingungen einrichten, sowie Kommandos, die anschließend die Ausführung einer Datenverarbeitung starten. Die Anweisungen an den Simulator 24 beinhalten insbesondere Angaben zu den von einer auszutestenden Chipkarte 10 erwarteten Sollantworten und zur daraus jeweils resultierenden weiteren Testprozedurausführung.

Zur Durchführung und Steuerung des Erstellungsprozesses besitzt die Testentwurfsstation 40 einen Entwurfseditor 45. Er ist vorzugsweise in Form eines von der zentralen Prozessoreinheit 41 ausführbaren Programmes realisiert und in der Speichereinrichtung 42 abgelegt.

Der Entwurfseditor 45 arbeitet grundsätzlich nach Art eines üblichen Editors. Er steuert das Eingeben und Ändern von Daten gemäß über die Eingabemittel 43 zugeführten Vorgaben eines Testingenieurs und bewirkt die visuelle Wiedergabe von Daten auf der Anzeige 44 zur Rückmeldung an der Testingenieur. Vorzugsweise erfolgt die Wiedergabe in mehreren übereinanderliegenden graphischen Ebenen, zwischen denen ein Testingenieur bei der Erstellung eines Testskriptes wechseln kann, um unterschiedliche Ansichten eines bearbeiteten Testskriptes zu erhalten.

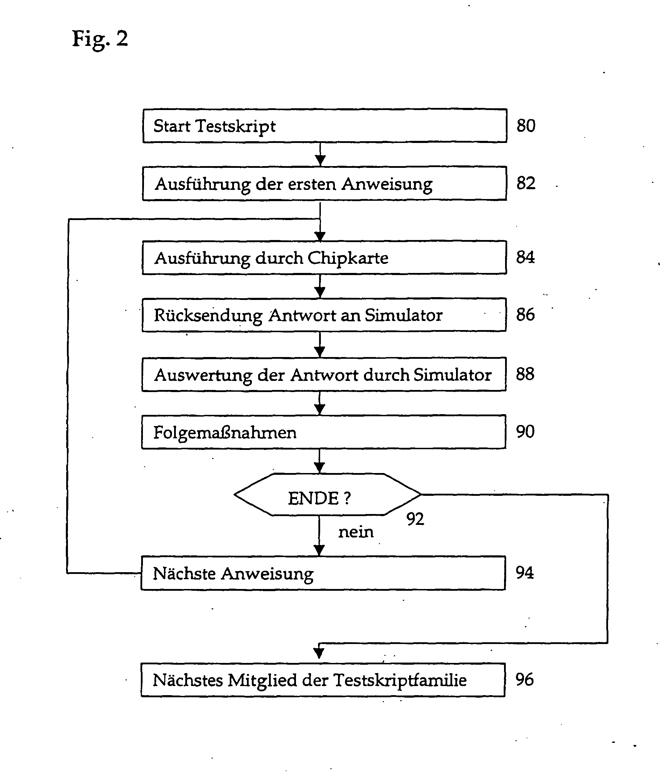

Figur 2 illustriert das Grundprinzip der Ausführung eines Testskriptes durch einen Simulator 24, um die Funktionsfähigkeit einer Chipkarte 10 zu testen. Das veranschaulichte Grundprinzip gilt dabei nicht nur für Chipkarten 10 sondern völlig analog auch allgemein für das Austesten eines beliebigen integrierten Schaltkreises 12 durch eine Prüfeinrichtung 20.

Getestet werden bei Chipkarten 10 üblicherweise die Funktion des Betriebssystems und/oder ausführbare Anwendungen. Die Ausführung setzt ein mit dem Start eines Testskriptes, Schritt 80, woraufhin der Simulator 24 die erste in dem Testskript enthaltene Anweisung ausführt und ein entsprechendes Kommando an die Chipkarte 10 sendet, Schritt 82.

Das vom Simulator 24 erhaltene Kommando führt die Chipkarte 10 aus, Schritt 84, und nimmt eine entsprechende Datenverarbeitung vor. Das Ergebnis der Datenverarbeitung übermittelt sie über die Schnittstellen 11, 21 als Antwort zurück an den Simulator 24, Schritt 86.

Dieser wertet die Antwort aus, Schritt 88, indem er sie beispielsweise mit einer im Testskript angegebenen Sollantwort vergleicht. Aufgrund der Auswertung kann vorgesehen sein, daß besondere Folgemaßnahmen ausgeführt werden, Schritt 90, etwa die unmittelbare Ausgabe einer Fehlermeldung an die Anzeige 44 zur Kenntnisnahme durch den Testingenieur, wenn die zurückerhaltene Antwort nicht mit der Sollantwort übereinstimmt.

Nachfolgend prüft der Simulator 24, ob das Testskript weitere Anweisungen aufweist, Schritt 92. Bejahendenfalls führt es diese ebenfalls aus und wiederholt die Schritte 84 ff.

Ergibt die Prüfung in Schritt 92, daß die letzte Anweisung eines Testskriptes ausgeführt wurde, prüft der Simulator 24, ob ein weiteres unmittelbar auszuführendes Testskript vorliegt, Schritt 94. Gegebenenfalls führt er dieses aus.

Die Erstellung der vom Simulator 24 ausgeführten Testskripte erfolgt mit Hilfe des Entwurfseditors 45 an der Testentwurfsstation 40 durch einen Testingenieur unter Verwendung der Eingabemittel 43 und der Anzeige 44. Erstellt werden Testskriptfamilien. Dies sind Serien von Testskripten, welche sich jeweils von einem gemeinsamen Basistestskript ableiten. Das Basistestskript beschreibt dabei den ersten Testfall in einem allgemeinen Testszenario, d.h. eine erste ausgewählte und vorzugsweise erprobte Folge Anweisungen, welche die Chipkarte 10 bei definierten Vorgaben zu bestimmten Datenverarbeitungen veranlassen. Aus dem Basistestskript werden weitere Testskripte abgeleitet. Die abgeleiteten Testskripte beschreiben im Rahmen desgleichen Testszenarios weitere Testfälle, welche sich aus dem Basistestskript jeweils durch Modifikation einzelner Anweisungen, d.h. durch Modifikation einzelner Parameter, Daten oder bestimmter Kommandos, ergeben.

Voraussetzung für die Durchführung des erfindungsgemäßen Verfahrens ist das Vorhandensein eines ausführbaren fehlerfreien Basistestskriptes. Das Basistestskript wird in herkömmlicher Weise von einem Testingenieur erstellt. Bei der Herstellung können insbesondere Methoden zur Anwendung kommen, wie sie aus der in der Beschreibungseinleitung genannten Literatur bekannt sind. Auf dem Gebiet der Chipkarten 10 basiert die Erstellung des Basistestskriptes zweckmäßig auf der für das Verhalten einer Chipkarte 10 vorgegebenen Spezifikation. Häufig existieren auch bereits erprobte Muster-Basistestskripte, von denen zunächst ausgegangen werden kann. Von diesen Vorgaben und/oder vorhandenen Informationen ausgehend erstellt ein Testingenieur unter Heranziehung seiner Vorkenntnisse und unter Nutzung heuristischer Methoden eine Sequenz von Kartenkommandos, zugehörigen Parametern und vorgegebenen Kartenantworten, welche das Basistestskript für den ersten Testfall eines Testszenarios definieren.

Regelmäßig erfolgt das Austesten der Funktionsfähigkeit einer Chipkarte 10 in mehreren Testszenarien. Für jedes Testszenario, das ausgetestet werden soll, ist ein Basistestskript zu erstellen. Das Basistestskript wird erprobt und ist ausführbar.

Liegt wenigstens ein ausführbares Basistestskript vor, erfolgt anschließend erfindungsgemäß die Erstellung von weiteren abgeleiteten Testskripten. Bei diesem Prozeß wird der Testingenieur von der Testentwurfsstation 40 durch eine besondere visuelle Darstellung unterstützt.

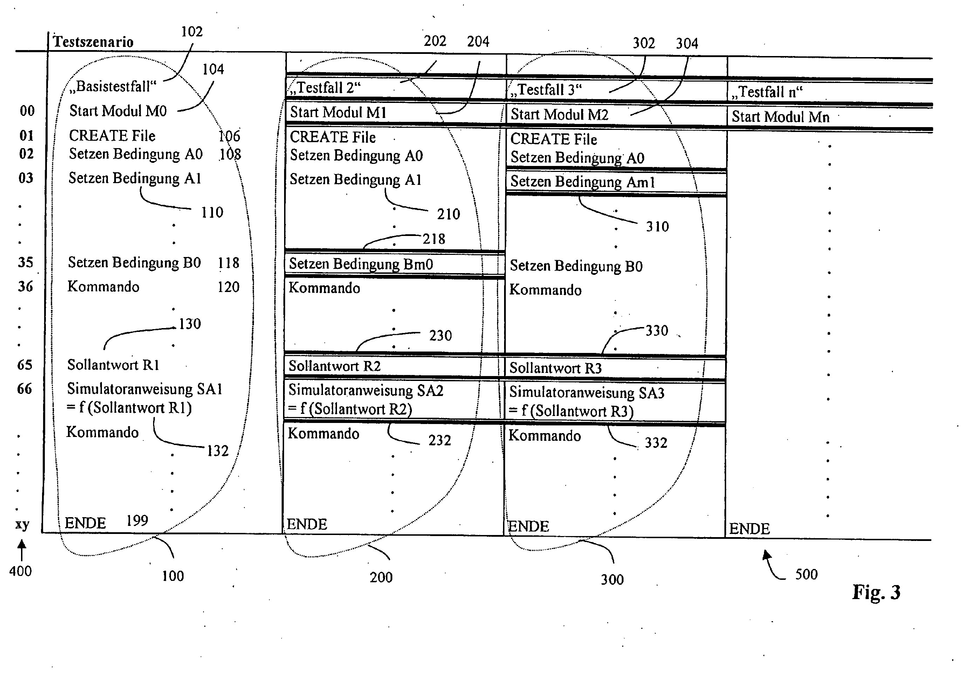

Anhand Figur 3 wird die Erstellung von aus einem Basistestskript abgeleiteten Testskripten näher beschrieben.

Figur 3 veranschaulicht die Wiedergabe eines Basistestskriptes 100 sowie daraus abgeleiteter Testskripte 200, 300 auf der Anzeige 44 einer Testentwurfsstation 40 während der Erstellung. Gezeigt sind dabei nur die für das hier beschriebene Verfahren tatsächlich relevanten Elemente; alle nicht unmittelbar verfahrensrelevanten Hilfselemente, auch solche, die sonst regelmäßig auf Anzeigen 44 wiedergegeben werden, wurden der Übersichtlichkeit wegen weggelassen.

Die Erstellung des ersten abgeleiteten Testskriptes 200 beginnt, indem der Entwurfseditor 45 auf der Anzeige 44 das Basistestskript 100 zur Darstellung bringt, von dem ausgegangen wird. Zusammen mit dem Basistestskript 100 bringt der Entwurfseditor 45 auf der Anzeige 44 weiterhin die Grundform des ersten abgeleiteten Testskriptes 200 zur Darstellung. In seiner Grundform ist das abgeleitete Testskript 200 zunächst identisch mit dem Basistestskript 100. Die Wiedergabe von Basistestskript 100 und abgeleitetem Testskript 200 erfolgt, wie in Figur 3 angedeutet, zum Beispiel zeilenweise. Die Zeilen sind zweckmäßig mit einem Index 400 versehen, der sie durchnumeriert. Die Anweisungszeilen des Basistestskriptes 100 und des abgeleiteten Testskriptes 200 werden vom Entwurfseditor 45 bei der gemeinsamen Wiedergabe auf der Anzeige 44 so zueinander plaziert, daß einander entsprechende, zunächst identische Anweisungen für einen Betrachter der Anzeige 44 aufgrund ihrer Plazierung unmittelbar als identisch zu erkennen sind. Bei zeilenweiser Wiedergabe sind etwa Zeilen mit gleichen Anweisungen jeweils gemeinsam auf einer virtuellen oder auch gezeigten horizontalen Linie nebeneinander angeordnet.

Das Basistestskript 100 besitzt zweckmäßig eine seine Handhabung unterstützende Struktur. Eine erste Zeile 102 des Basistestskriptes 100 bezeichnet im Beispiel Fig. 3 das Testskript mit einem Namen. Eine folgende Zeile 104 enthält eine Anweisung für den Simulator 24, ein bestimmtes Testskript auszuführen und nennt die genaue Bezeichnung des Testskriptes, unter der es in den Speichermitteln 42 abgelegt ist.

Folgende Zeilen 106,108,110 enthalten Anweisungen für die Chipkarte 10, welche das auszutestende Testszenario einrichten. Wie angedeutet, kann eine erste Anweisung, zum Beispiel die Anweisung "CREATE FILE" die Chipkarte 10 etwa veranlassen, eine Datei anzulegen; in die angelegte Datei werden nachfolgend dann beispielsweise bestimmte Daten eingeschrieben. Andere typische Anweisungen zur Einrichtung eines Testszenarios sind Anweisungen zum Setzen von Bedingungen und Vorgaben.

Eine weitere Zeile 120 enthält ein Kommando, das die Chipkarte 10 veranlaßt, einen mit dem Kommando übergebenen Wert in bestimmter Weise zu verarbeiten. Ein solches Kommando kann beispielsweise die Berechnung eines Schlüssels nach Übergabe einer Zufallszahl sein.

Eine weitere Zeile 130 des Basistestskriptes 100 enthält eine für den Simulator 24 bestimmte Anweisung mit der von der Chipkarte 10 zu erwartenden Antwort. Die Anweisung kann ferner Angaben enthalten, welche Folgemaßnahmen in Abhängigkeit von der Antwort der Chipkarte 10 vorgenommen werden sollen.

Je nach Testszenario kann das Basistestskript 100 mehrere Anweisungsfolgen der vorgenannten Art enthalten, d.h. von Anweisungen, mit denen die Chipkarte 10 zunächst in bestimmter Weise eingestellt wird, gefolgt von Anweisungen, die das erwartete Antwortverhalten der Chipkarte 10 auf ein bestimmtes Kommando vorgeben.

In üblicher Weise schließt das Basistestskript 100 mit einer ENDE-Anweisung 199.

Das abgeleitete Testskript 200 entspricht zunächst identisch dem Basistestskript 100, so daß Zeilen mit gleichem Zeilenindex 400 in Basistestskript 100 und abgeleitetem Testskript 200 übereinstimmen.

In einem ersten Erstellungsschritt modifiziert nun der Testingenieur unter Verwendung der Eingabemittel 43 in dem abgeleiteten Testskript 200 die Zeile 202 mit der Namen sowie die Zeile 204 mit der Speicherbezeichnung. Die durch die Modifikation hergestellte Ungleichheit zwischen den Zeilen 202 und 204 im abgeleiteten Testskript 200 und den zugrundeliegenden, ursprünglich identischen Anweisungszeilen 102 und 104 im Basistestskript 100 erkennt der Entwurfseditor 45. Er formatiert daraufhin selbsttätig in dem abgeleiteten Testkript 200 die geänderten Zeilen 202, 204 um und bewirkt auf der Anzeige 44 eine veränderte Wiedergabe der Zeilen. Durch die geänderte Wiedergabe werden die modifizierten Zeilen 202, 204 gegenüber den übrigen Anweisungszeilen des abgeleiteten Testskriptes 200 und auch gegenüber dem Basistestskript 100 visuell hervorgehoben, so daß sie für einen Testingenieur unmittelbar wahrnehmbar ist. Die Hervorhebung kann zum Beispiel durch Unterlegen der Anweisungszeilen 202, 204 mit einer abweichenden Farbe oder, wie in Figur 3 angedeutet, durch besondere Umrandung der betroffenen Zeilen erfolgen.

Im folgenden Schritt modifiziert der Testingenieur eine der zur Einrichtung der Chipkarte 10 genutzten Anweisungen, indem er etwa eine zu setzende Bedingung "B0" durch eine andere Bedingung "Bm0" ersetzt. Die durch die Modifikation hergestellte Ungleichheit zwischen der modifizierten Anweisungszeile 218 im abgeleiteten Testskript 200 und der zugrundliegenden, ursprünglich identischen Anweisungszeile 118 im Basistestskript 100 wird wieder von dem Entwurfseditor 45 erkannt. Er formatiert daraufhin wiederum selbsttätig die geänderte Zeile 218 in dem abgeleiteten Testkript 100 um und bewirkt auf der Anzeige 44 eine veränderte Wiedergabe der modifizierten Zeile 218. Durch die geänderte Wiedergabe wird, wie zuvor die Zeilen 202, 204, auch die modifizierte Zeile 218 sowohl gegenüber den übrigen Anweisungszeilen des abgeleiteten Testskriptes 200 als auch gegenüber dem Basistestskript 100 visuell hervorgehoben, so daß die Modifikation für einen Testingenieur unmittelbar wahrnehmbar ist. Die Hervorhebung erfolgt zweckmäßig in dergleichen Weise wie die Hervorhebung der Zeilen 202, 204, also etwa durch Unterlegen mit einer abweichenden Farbe oder, wie in Figur 3 angedeutet, durch besondere Umrandung der betroffenen Zeile.

Bedingt die Modifikation der Anweisungszeile 218 im abgeleiteten Testskript 200 die Einfügung einer neuen Anweisungszeile, zu der sich im Basistestskript 100 keine Entsprechung findet, so formatiert der Entwurfseditor 45 selbsttätig auch das Basistestskript 100 um. Dabei fügt er in das Basistestskript 100 hinter die der ersten modifizierten Zeile entsprechenden Anweisungszeile soviele Leerzeilen ein, daß die erste auf die modifizierte Zeile 218 folgende, unverändert gebliebene Zeile im abgeleiteten Testskript 200 in Bezug auf den Zeilenindex 400 wieder auf gleicher Höhe mit der entsprechenden Zeile im Basistestskript 100 liegt und beide sofort als übereinstimmend erkennbar sind.

Führt die Modifikation der Anweisungszeile 218 im abgeleiteten Testskript 200 zu einer Verminderung der Anweisungszeilen des abgeleiteten Testskriptes 200, so fügt der Entwurfseditor 45 in das abgeleitete Testskript 200 hinter die letzte modifizierte Zeile selbsttätig genau so viele Leerzeilen ein, wie durch die Modifikation entfallen sind. Die nächste von der Modifikation nicht betroffene Zeile befindet sich dadurch wieder auf derselben horizontalen Höhe und führt denselben Zeilenindex 400 wie die entsprechende Zeile im Basistestskript 100.

Eine Änderung in den ursächlichen Bedingungen eines Testszenarios führt in der Regel zu einer Änderung der Datenverarbeitung auf der Chipkarte 10 und damit zu einer Änderung des Verhaltens der Chipkarte 10. Insbesondere gibt die Chipkarte 10 in der Regel eine gegenüber dem Zustand vor Änderung der Bedingung geänderte Antwort an den Simulator 24 zurück. Dies wiederum erfordert von dem Simulator 24 in der Regel eine veränderte Reaktion und damit eine Änderung im Testskript.

In einem folgenden Erstellungsschritt modifiziert der Testingenieur deshalb in dem abgeleiteten Testskript 200 diejenigen Anweisungen 230, 232, die das aufgrund der zuvor modifizieren Anweisung zu erwartende Verhalten der Chipkarte 10 behandeln und die weitere Testskriptausführung durch den Simulator 24 festlegen. Beispielsweise kann sich infolge der Änderung einer ursächlichen Bedingung eine neue Sollantwort R2 ergeben. Aufgrund der neuen Sollantwort kann eine veränderte Reaktion des Simulators 24 notwendig sein.

Vorteilhaft ist der Entwurfseditor 45 dazu eingerichtet, selbsttätig diejenigen Anweisungszeilen zu ermitteln, die als Folge der Modifikation einer vorhergehenden ursächlichen Anweisung 218 ebenfalls modifiziert werden müssen. Auf der Anzeige 44 bewirkt ein so eingerichteter Entwurfseditor 45 dann eine für den Testingenieur leicht wahrnehmbare Kennzeichnung der in Betracht kommenden Zeilen, etwa durch farbige Unterlegung, durch Verwendung eines anderen Schrifttyps oder durch Umrahmung.

Der durch die Modifikation der Folgeanweisungen 230, 232 entstandenen Unterschied zwischen Basistestskript 100 und abgeleitetem Testskript 200 wird ebenfalls von dem Testskritpteditor 45 erkannt. Wie bei der Änderung der ursächlichen Bedingung in Zeile 218 bewirkt der Entwurfseditor 45 wieder eine optisch hervorgehobene Darstellung der geänderten Anweisungen 230, 232 auf der Anzeige 44. Gegebenenfalls nimmt er ferner wiederum durch Einfügung von Leerzeilen selbsttätig eine Anpassung des Basistestskriptes 100 vor, wenn durch die Modifikation im abgeleiteten Testskript 200 Zeilen hinzugefügt wurden. Im Falle einer Verminderung der Anweisungszeilen im abgeleiteten Testskript 200 fügt er im Basistestskript 100 selbsttätig Leerzeilen ein, so daß die nächste folgende unveränderte Anweisungszeile wiederum in Bezug auf den Zeilenindex 400 auf derselben Höhe liegt wie die entsprechende Zeile im Basistestskript 100.

Die beiden Grundschritte Ändern einer ursächlichen Anweisung - anschließend Ändern einer Folgeanweisung für den Simulator 24 zur Berücksichtigung der durch die geänderte ursächliche Anweisung resultierenden geänderten Antwort der Chipkarte 10 wiederholt der Testingenieur so oft, bis durch das entstehende abgeleitete Testskript 200 ein zweiter Testfall vollständig beschrieben ist.

Durch die vom Entwurfseditor 45 jeweils vorgenommene Umformatierung aller Modifikationen im abgeleiteten Testskript 200 zur optischen Hervorhebung hat der Testingenieur jederzeit einen vollständigen Überblick über alle vorgenommenen Änderungen und ihre Auswirkungen und kann dadurch eventuelle Fehler in den Modifikationen oder die Notwendigkeit zur Vornahme weiterer Modifikationen leicht erkennen.

Neben der Bearbeitung von abgeleiteten Testskripten 200 kann der Testingenieur bei der Testskripterstellung auch Änderungen im Basistestskript 100 vorsehen. Erfolgt eine solche Änderung im Basistestskript 100, so nimmt der Entwurfseditor 45 dieselbe Änderung automatisch jeweils auch an allen bis dahin erstellten abgeleiteten Testskripten 200 vor. Entfiele etwa in dem Beispiel in Fig. 3 im Basisitestskript 100 die Anweisung 110 zum Setzen der Bedingung "A0", so würde diese Anweisung auch aus allen abgeleiteten Testskripten 200, 300 entfernt.

Im Anschluß an die Erstellung eines ersten abgeleiteten Testskriptes 200 erstellt der Testingenieur ein weiteres abgeleitetes Testskript. Als Grundlage hierfür stellt der Entwurfseditor 45 wieder ein Testskript 300 bereit, das zunächst bis auf den Namen 302 identisch mit dem Basistestskript 100 übereinstimmt. Die Darstellung erfolgt dabei je nach Beschaffenheit der Anzeige 44 und Wahl des Testingenieurs so, daß das abgeleitete Testskript 300 entweder unmittelbar benachbart zu dem Basistestskript 100 oder aber benachbart zu dem vorher erzeugten Basistestskript 200 wiedergegeben wird. Auch in letzterem Fall wird aber das Basistestskript 100 auf der Anzeige 44 dargestellt. Das abgeleitete Testskript 300 ist wiederum so angeordnet, daß seine Anweisungszeilen in Bezug auf den Zeilenindex 400 jeweils auf der gleichen Höhe liegen wie die entsprechenden Anweisungszeilen im Basistestskript 100.

Nachfolgend nimmt der Testingenieur eine Änderung einer ursächlichen Bedingung 310 im abgeleiteten Testskript 300 vor. In der Regel ist diese Änderung verschieden von der an dem ersten abgeleiteten Testskript 200 vorgenommenen Bedingungsänderung.

Entsprechend der vorgenommenen Bedingungsänderung ändert der Testingenieur sodann wieder die für den Simulator 24 bestimmte Anweisungszeile 330, welche die in Folge der geänderten ursächlichen Eingangsbedingung geänderte Antwort der Chipkarte 10 berücksichtigt. Wie bei der Erstellung des ersten Testskriptes 200 wiederholt der Testingenieur die Änderungsschritte so oft, wie das zur Beschreibung des Testfalles erforderlich ist.

Durch Wiederholen des vorgeschriebenen Vorgehens mit jeweils anderen Modifikationen erstellt der Testingenieur weitere Testskripte 300, 500. Ist dabei aufgrund der geometrischen Beschränktheit der Anzeige 44 eine Darstellung aller Testskripte 100, 200, 300, 500 nicht möglich, entfernt der Entwurfseditor 45 so viele der abgeleiteten Testskripte 200, 300, bis das Basistestskript 100 und zumindest das aktuell in der Erstellung befindliche abgeleitete Testskript 300, 500 auf der Anzeige 44 sichtbar sind. Zweckmäßig bietet der Entwurfseditor 45 für den Fall, daß die Zahl der zu einem Testszenario erstellten Testskripte 100, 200, 300, 500 größer ist als die Zahl der auf der Anzeige 44 gleichzeitig darstellbaren Testskripte, einen Scroll-Mechanismus an, mit dem alle erstellten abgeleiteten Testskripte 200, 300, 500 nacheinander auf der Anzeige 44 dargestellt werden. Dabei wird stets das Basistestskript 100 auf der Anzeige 44 gehalten.

Zweckmäßig bietet der Entwurfseditor 45 ferner einen weiteren Scroll-Mechanismus, um Blöcke von Anweisungszeilen 102 bis 199 eines Testskriptes 100, 200, 300, 500 nacheinander auf die Anzeige 44 aufzurufen. Mit dem Basistestskript 100 werden dabei stets die auf der Anzeige 44 befindlichen abgeleiteten Testskripte 200, 300 gescrollt, so daß einander entsprechende Anweisungszeilen 110, 210, 310,118, 218 stets gleichzeitig wiedergegeben werden und im Bezug auf dem mitlaufenden Zeilenindex 400 auf derselben Höhe liegen.

Der Entwurfseditor 45 kann mit herkömmlichen, im Handel erhältlichen Softwarewerkzeugen realisiert werden, beispielsweise auf der Basis von "Microsoft Excel©" durch "Visual Basic©"-Makros und Anwendung der bedingten Formatierung.

In einer vorteilhaften Ausgestaltung ist der Entwurfseditor 45 als Computerprogrammprodukt ausgebildet, indem der den Entwurfseditor 45 realisierende Programmcode auf einem aus der Testskripterstellungsstation 40 herausnehmbaren, tragbaren magnetischen oder optischen Datenträger gespeichert ist. Das solchermaßen ausgebildete Computerprogrammprodukt kann dann in einer Vielzahl von Testanordnungen nach Art der in Figur 1 gezeigten eingesetzt werden. Beispielsweise ist der Entwurfseditor 45 auf einen transportablen Wechseldatenträger, etwa einer Compact Disc (CD) abgespeichert, so daß er durch einfaches Umsetzen der CD auf verschiedenen Testentwurfsstationen 40 ausgeführt werden kann. Die Ausgestaltung des Entwurfseditors 45 als Computerprogrammprodukt ermöglicht es auch, einem herkömmlichen Computer mit Eingabeeinrichtung 43 und Anzeige 44 die Funktionalität einer Testskripterstellungsstation 40 zu verleihen.

Das vorgeschlagene Verfahren gestattet im Rahmen des Grundkonzeptes, Testsprozeduren ausgehend von einer Basistestprozedur herzustellen, indem die Unterschiede durch geeignete hervorgehobene Darstellung unmittelbar wahrnehmbarer gemacht werden, eine Vielzahl von Ausgestaltungen. Insbesondere gilt dies für die Darstellung der einzelnen Testprozeduren 100, 200, 300 auf der Anzeige 44 und die Veranschaulichung der Unterschiede zwischen dem Basistestsprozedur 100 und einem abgeleiteten Testprozedur 200, 300. Neben dem in Figur 3 angedeuteten zeilenweisen Darstellung ist beispielsweise genauso eine spaltenweise Gegenüberstellung von Basistestprozedur 100 und abgeleiteter Testprozedur 200, 300 möglich. In weitem Rahmen gestaltbar ist auch die Art und Weise, wie die Basistestprozedur 100 und die verschiedenen abgeleiteten Testsprozeduren 200, 300, 500 einer Testsprozedurfamilie vergleichend zur Darstellung gebracht werden. Insbesondere kann hierbei die Zahl der gleichzeitig dargestellten Testprozeduren 100, 200, 300, 500 und die Abfolge der jeweils dargestellten abgeleiteten Testprozeduren 200, 300, 500 variiert werden.

Auf der Anzeige 44 werden in der Regel ferner neben den Testprozeduren 100, 200, 300, 500 in üblicher Weise Hilfsinformationen wiedergegeben, insbesondere Steuerelemente zur Bedienung von Bearbeitungsprogrammen, mit denen die Vornahme der Erstellung der Testprozeduren erfolgt, sowie weitere Verwaltungsinformationen zum Ablegen und Wiederaufinden der Testprozeduren in den Speichermitteln 42 der Testanordnung.

## Patentansprüche

1. Verfahren zum Erzeugen einer Testprozedur zum Austesten der Funktionsfähigkeit einer datenverarbeitenen Schaltung einer Chipkarte, welche über einen definierten Kommandosatz mit der Außenwelt kommuniziert, mittels eines Simulators, wobei die Testprozedur eine Sequenz von Anweisungen für die datenverarbeitende Schaltung zur Herbeiführung einer Antwort sowie Anweisungen zur Steuerung der Durchführung der Testprozedur für den Simulator, insbesondere Angaben zur Behandlung der Antwort enthält, **gekennzeichnet durch** folgende Schritte:
a) Bereitstellen einer lauffähigen Basistestprozedur (100), wobei die Anweisungen für die datenverarbeitende Schaltung Kommandos, Parameter und Daten, die bestimmte Testbedingungen einrichten, und die Anweisungen für den Simulator Angaben zu erwarteten Sollantworten und zu einer daraus jeweils resultierenden weitern Ausführung der Testprozedur enthalten,
b) Wiedergabe der Anweisungen der Basistestprozedur (100) auf einer Anzeige (44),
c) Erzeugen einer Kopie der Basistestprozedur (100),
d) Darstellen der Kopie zusammen mit der Basistestprozedur (100) auf der Anzeige (44), so daß gleiche Anweisungen unmittelbar als einander entsprechend wahrnehmbar sind,
e) Modifizieren einer zur Herbeiführung einer Antwort dienenden Anweisung für die datenverarbeitende Schaltung (10) in der Kopie (200) der Basistestprozedur (100),
f) Umformatieren der modifizierten Anweisung, um sie auf der Anzeige (44) anders wiederzugeben als die entsprechende ursprüngliche Anweisung der Basistestprozedur (100),
g) Umformatieren der Darstellung der Basistestprozedur (100) so, daß die nächste auf die modifizierte folgende Anweisung unmittelbar als die nächster auf die modifizierte folgenden Anweisung in der Kopie der Basistestprözedur entsprechend wahrnehmbar ist,
h) Wiederholen der Schritte e) bis g) für eine Anweisung an den Simulator (24), welche die Behandlung der Soll-Antwort der datenverarbeitenden Schaltung (10) auf die modifizierte Anweisung steuert.

2. Verfahren nach Anspruch 1, **dadurch gekennzeichnet, daß** Basistestprozedur (100) und abgeleitete Testprozedur (200, 300) zeilenweise nebeneinander angeordnet werden.

3. Verfahren nach Anspruch 1, **dadurch gekennzeichnet, daß** die Umformatierung eine visuell hervorgehobene Darstellung der Modifikationen bewirkt.

4. Verfahren nach Anspruch 1 **dadurch gekennzeichnet, daß** die Speicherung der abgeleiteten Testprozeduren (200, 300) erfolgt, indem nur die Abweichungen von der Basisprozedur (100) gespeichert werden.

5. Verfahren nach Anspruch 1 **dadurch gekennzeichnet, daß** Modifikationen in der Basisprozedur (100) unmittelbar auch in allen vorhandenen, von der Basisprozedur (100) abgeleiteten Testprozeduren (100, 200, 300) vorgenommen werden.

6. Testentwurfsstation auf Basis eines Computers zur Ausführung aller Schritte des Verfahrens nach Anspruch 1, mit einer Anzeige, einer Eingabeeinrichtung sowie einem Entwurfseditor, welcher bei der Erstellung einer Testprozedur die Anzeige steuert, **dadurch gekennzeichnet, daß**
- der Entwurfseditor (45) geeignet ist eine Basistestprozedur (100) zusammen mit einer abgeleiteten Testprozedur (200) auf der Anzeige (44) zur Wiedergabe zubringen, wobei Basistestprozedur (100) und abgeleitete Testprozedur (200) so zueinander plaziert werden, daß einander entsprechender Anweisungen unmittelbar als solche erkennbar sind,
- und der Entwurfseditor (45) geeignet ist die Wiedergabe der abgeleiteten Testprozedur (200) nach Vornahme einer Modifikation umzuformatieren, so daß die Modifikation im Vergleich zu der Basistestprozedur (100) unmittelbar erkennbar ist.

7. Testentwurfsstation nach Anspruch 6, **dadurch gekennzeichnet, daß** der Entwurfseditor (45) dazu geeignet ist Basistestprozedur (100) und abgeleitete Testprozedur (200) nebeneinander wiederzugeben, so daß einander entsprechende Anweisungen jeweils in derselben Zeile (400) angeordnet sind.

8. Testentwurfsstation nach Anspruch 6, **dadurch gekennzeichnet, daß** die Umformatierung eine visuell wahrnehmbare Wiedergabe der Modifikationen bewirkt.

9. Computerprogrammprodukt zum Einrichten einer Testanordnung zur Ausführung aller Schritte des Verfahrens nach Anspruch 1, bestehend aus einem tragbaren Datenträger, auf dem Programmcode zur Durchführung des Verfahrens nach einem der Ansprüche 1-5 abgelegt ist, wobei der Programmcode enthält:
eine Programmfunktion, um auf einer Anzeige (44) eine Basistestprozedur (100) zusammen mit einer Grundform einer abgeleiteten Testprozedur (200) zur Wiedergabe zu bringen,
eine Programmfunktion, um Unterschiede zwischen der abgeleiteten Testprozedur (200) und der Basistestprozedur (100) festzustellen, und eine Programmfunktion, um die festgestellten Unterschiede umzuformatieren, so daß sie in der Wiedergabe auf der Anzeige (44) unmittelbar wahrnehmbar sind.

10. Verwendung eines Verfahrens nach Anspruch 1 zur Erstellung einer Testprozedur zum Austesten der Funktionsfähigkeit einer Chipkarte (10).

11. Verwendung einer Testentwurfsstation nach Anspruch 6 zur Erstellung einer Testprozedur zum Austesten der Funktionsfähigkeit einer Chipkarte (10).

## Claims

1. A method of generating a test procedure for testing the functionality of a data-processing circuit of a chip card, which communicates with the outside world using a defined set of commands, by means of a simulator, the test procedure comprising a sequence of instructions for the data-processing circuit for producing a response together with instructions for controlling performance of the test procedure for the simulator, in particular information regarding handling of the response, **characterised by** the following steps:
a) providing an executable basic test procedure (100), the instructions for the data processing circuit comprising commands, parameters and data, which set up particular test conditions, and the instructions for the simulator comprising information regarding expected desired responses and regarding further execution of the test procedure in each case resulting therefrom,
b) reproducing the instructions of the basic test procedure (100) on a display (44),
c) generating a copy of the basic test procedure (100),
d) representing the copy together with the basic test procedure (100) on the display (44), such that identical instructions may be immediately perceived as corresponding to one another,
e) modifying an instruction serving to produce a response for the data processing circuit (10) in the copy (200) of the basic test procedure (100),
f) reformatting the modified instruction, in order to reproduce it differently on the display (44) from the corresponding original instruction of the basic test procedure (100).
g) reformatting the representation of the basic test procedure (100) in such a way that the next instruction following the modified instruction may be immediately perceived as corresponding to the next instruction following the modified instruction in the copy of the basic test procedure,
h) repeating steps e) to g) for an instruction to the simulator (24) which controls handling of the desired response of the data processing circuit (10) to the modified instruction.

2. A method according to claim 1, **characterised in that** basic test procedure (100) and derived test procedure (200, 300) are arranged next to one another line-by-line.

3. A method according to claim 1, **characterised in that** the reformatting brings about a visually highlighted representation of the modifications.

4. A method according to claim 1, **characterised in that** storing of the derived test procedures (200, 300) is effected by storing only the deviations from the basic procedure (100).

5. A method according to claim 1, **characterised in that** modifications to the basic procedures (100) are also effected immediately in all the available test procedures (100, 200, 300) derived from the basic procedure (100).

6. A test design station based on a computer for executing all the steps of the method according to claim 1, having a display, an input means and a design editor, which controls the display when drawing up a test procedure, **characterised in that**
- the design editor (45) is suited to reproducing a basic test procedure (100) together with a derived test procedure (200) on the display (44), basic test procedure (100) and derived test procedure (200) being placed relative to one another in such a way that mutually corresponding instructions are immediately recognisable as such,
- and the design editor (45) is suited to reformatting the reproduction of the derived test procedure (200) after effecting a modification, such that the modification is immediately recognisable in comparison to the basic test procedure (100).

7. A test design station according to claim 6, **characterised in that** the design editor (45) is suited to reproducing basic test procedure (100) and derived test procedure (200) next to one another, such that mutually corresponding instructions are in each case arranged on the same line (400).

8. A test design station according to claim 6, **characterised in that** the reformatting brings about a visually perceptible reproduction of the modifications.

9. A computer program product for installing a test arrangement for executing all the steps of the method according to claim 1, consisting of a portable data carrier, on which program code for performing the method according to any one of claims 1 to 5 is stored, the program code comprising:
- a program function for reproducing a basic test procedure (100) together with a basic form of a derived test procedure (200) on a display (44),
- a program function for identifying differences between the derived test procedure (200) and the basic test procedure (100), and
- a program function for reformatting the identified differences, such that they are immediately perceptible in the reproduction on the display (44).

10. Use of a method according to claim 1 for drawing up a test procedure for testing the functionality of a chip card (10).

11. Use of a test design station according to claim 6 for drawing up a test procedure for testing the functionality of a chip card (10).

## Revendications

1. Procédé pour générer une procédure de test pour tester le bon fonctionnement d'un circuit de traitement de données d'une carte à puce, qui communique au moyen d'un ensemble d'instructions définies avec le monde extérieur, au moyen d'un simulateur, la procédure de test contenant une séquence d'instructions pour le circuit de traitement de données pour entraîner une réponse et des directives pour la commande de l'exécution de la procédure de test pour le simulateur, en particulier des indications pour le traitement de la réponse, **caractérisé par** les étapes suivantes :
a) mise à disposition d'une procédure de test de base (100) exécutable, les directives pour le circuit de traitement de données contenant des instructions, des paramètres et des données qui mettent en place certaines conditions de test, et les directives pour le simulateur contenant des indications relatives aux réponses théoriques à escompter et une autre exécution de la procédure de test qui en résulte respectivement,
b) restitution des directives de la procédure de test de base (100) sur un affichage (44),
c) génération d'une copie de la procédure de test de base (100),
d) présentation de la copie en même temps que la procédure de test de base (100) sur l'affichage (44), de sorte que des directives identiques peuvent être perçues directement comme des directives qui se correspondent,
e) modification d'une directive servant à entraîner une réponse pour le circuit (10) de traitement de données dans la copie (200) de la procédure de test de base (100),
f) reformatage de la directive modifiée, afin de la restituer à l'affichage (44) différemment de la directive initiale correspondante de la procédure de test de base (100),
g) reformatage de la présentation de la procédure de test de base (100), de telle sorte que la prochaine directive suivant la directive suivante modifiée peut être perçue de façon appropriée directement comme la prochaine directive suivant la directive suivante modifiée dans la copie de la procédure de test de base,
h) répétition des étapes e) à g) pour une directive envoyée au simulateur (24), qui commande le traitement de la réponse théorique du circuit de traitement de données (10) à la directive modifiée.

2. Procédé selon la revendication 1, **caractérisé en ce que** la procédure de test de base (100) et la procédure de test (200, 300) déduite sont disposées ligne par ligne l'une à côté de l'autre.

3. Procédé selon la revendication 1, **caractérisé en ce que** le reformatage entraîne une représentation mise en évidence visuellement des modifications.

4. Procédé selon la revendication 1, **caractérisé en ce que** le stockage des procédures de test (200, 300) déduites s'effectue par le fait que les écarts par rapport à la procédure de base (100) sont stockés.

5. Procédé selon la revendication 1, **caractérisé en ce que** des modifications dans la procédure de base (100) sont effectuées directement également dans toutes les procédures de test (100, 200, 300) existantes et déduites de la procédure de test (100).

6. Station de conception de test sur la base d'un ordinateur pour l'exécution de toutes les étapes du procédé selon la revendication 1, comprenant un affichage, un dispositif d'entrée et un éditeur de projet, qui commande l'affichage lors de l'établissement d'une procédure de test, **caractérisée en ce que**
- l'éditeur de projet (45) est approprié pour restituer une procédure de test de base (100) conjointement avec une procédure de test (200) déduite à l'affichage (44), la procédure de test de base (100) et la procédure de test (200) déduite étant placées l'une par rapport à l'autre de telle sorte que des directives qui se correspondent sont reconnaissables directement en tant que telles,
- et l'éditeur de projet (45) est approprié pour reformater la restitution de la procédure de test (200) déduite après l'exécution d'une modification, de sorte que la modification par rapport à la procédure de test de base (100) est directement reconnaissable.

7. Station de conception de test selon la revendication 6, **caractérisée en ce que** l'éditeur de projet (45) est approprié pour restituer la procédure de test de base (100) et la procédure de test (200) déduite l'une à côté de l'autre, de sorte que des directives qui se correspondent sont disposées à chaque fois sur la même ligne (400).

8. Station de conception de test selon la revendication 6, **caractérisée en ce que** le reformatage entraîne une restitution visuellement perceptible des modifications.

9. Produit de programme informatique pour mettre en place un dispositif de test pour l'exécution de toutes les étapes du procédé selon la revendication 1, comprenant un support de données portable, sur lequel le code de programme pour l'exécution du procédé selon l'une quelconque des revendications 1 à 5 est déposé, le code de programme contenant :
une fonction de programme, afin de restituer sur un affichage (44) une procédure de test de base (100) conjointement avec une forme de base d'une procédure de test (200) déduite,
une fonction de programme pour déterminer des différences entre la procédure de test (200) déduite et la procédure de test de base (100), et une fonction de programme, afin de reformater les différences constatées, de sorte qu'elles peuvent être directement perceptibles lors de la restitution à l'affichage (44).

10. Utilisation d'un procédé selon la revendication 1 pour l'élaboration d'une procédure de test pour tester le bon fonctionnement d'une carte à puce (10).

11. Utilisation d'une station de conception de test selon la revendication 6 pour l'élaboration d'une procédure de test pour tester le bon fonctionnement d'une carte à puce (10).
